# EUROPEAN PATENT APPLICATION

(11) **EP 3 293 825 A1**
(43) Date of publication of application: **14.03.2018**
(21) Application number: 17188272.3
(22) Date of filing: 29.08.2017
(51) Int. Cl.: H01Q 13/18, H01Q 9/04, H01Q 21/28, H01Q 1/24

(54) **DEVICE WITH CAVITY-BACKED ANTENNA ARRAY INTEGRATED IN A METAL CASING**

(30) Priority: 09.09.2016 EP 16306131
(71) Applicant: Thomson Licensing, 92130 Issy-les-Moulineaux (FR)
(72) Inventor: MINARD, Philippe, 35576 Cesson-Sévigné (FR); STEYER, Jean-Marie, 35576 Cesson-Sévigné (FR); BERTIN, Jean-Pierre, 35576 Cesson-Sévigné (FR); AUBIN, Anthony, 35576 Cesson-Sévigné (FR)
(74) Representative: Huchet, Anne

(57) **Abstract**

An electronic device (100) for wireless communication comprising a metal casing wherein the wireless communication is realized by at least one cavity-backed slot antenna. Each cavity is formed by the combination of the top housing (110), metallic walls, a ground plane at the top of a printed circuit board (140) and the bottom housing (150).

## Description

### TECHNICAL FIELD

The present invention relates generally to the field of wireless communication devices comprising a metal casing. The invention can be integrated into, but is not limited to, home-networking electronic devices, such as internet gateways, set-top-boxes, routers and smart home devices.

### BACKGROUND

This section is intended to introduce the reader to various aspects of art, which may be related to various aspects of the present disclosure that are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

Home-networking devices such as internet gateways, set-top-boxes routers and smart home devices integrate numerous wireless systems in order to offer multiple services and applications. These include different systems complying with various communication standards such as, for example, WiFi, Bluetooth, RF4CE, ZigBee, Zwave. Therefore, the electronic devices tend to integrate more and more antennas while they, at the same time, become smaller. Consequently, integration and coexistence constraints, as well as manufacturing and assembly costs, are increased sensitively.

Conventionally, the casing of such devices is made of plastic materials. The product casing can be realized in metal for different reasons. Metal high-end finishing metal surfaces provide a trendier and more aesthetical product. Better mechanical resistance and sealing capabilities make metal housings interesting for outdoor equipment. Metal casing comes with some advantages such as increased stability due to higher weight, reduced dimensions thanks to the increased robustness of the casing, more efficient thermal management, increased isolation from the noise embedded in the electronic product caused by electronic components, and better handling of Electromagnetic Compatibility (EMC) issues. Such metallic casing is manufactured using for example die casting or machining techniques. However, a complete metal housing prevents radio-frequency (RF) signals from flowing between the external environment and the internal components. Therefore, specific considerations must be taken particularly towards the antenna integration in order to preserve the performances of the wireless communications.

Solutions in the mobile phone industry allow to integrate antennas in a mobile phone with a metal casing. Proposed antenna solutions belong to cavity-backed patch or slot antenna types. However, most of these solutions are integrated on a small form factor device with a limited number of antennas. For a wireless communication device integrating multiple-input multiple-output (MIMO) WiFi capabilities or embedding multiple wireless communication systems, more than one antenna has to be integrated in the metal housing. Some of following constraints need to be considered to address this goal: a good angular coverage of the whole antenna system in order to minimize the performance (throughput) variations, low RF coupling between antennas and low cost mechanical solution within the context of a metal housing, the first one being particularly difficult to achieve in such a context.

### SUMMARY

It is an object of the invention to alleviate at least partially the above-mentioned drawbacks. More specifically, it is an object of the invention to integrate multiple cavity-backed antennas in a compact metal housing for a wireless communication device.

The present disclosure is about an electronic device configured to perform wireless communications, comprising a housing comprising a first part of housing and a second part of housing, said housing being realized in metallic material or realized in non-metallic material that is metallized on its surface, a printed circuit board comprising electronic components configured to provide at least wireless communications capabilities, the electronic components comprising at least a driving circuit for at least one antenna feeder, said printed circuit board comprising a ground plane on its top surface,
at least one cavity-backed antenna fed by an antenna feeder, wherein a first part of said cavity is formed by said first part of housing, said first part of housing comprising walls perpendicular to said first part, the dimensions and positions of said walls with regards to the antenna adjusting the resonating frequency and the quality factor of said cavity-backed antenna, a second part of said cavity is formed by the ground plane of the first surface of the printed circuit board and a third part of said cavity is formed by said second part of housing and a fourth part of said cavity is formed by walls erected from said first part of housing towards the first surface of the printed circuit board, the dimensions and positions of said walls with regards to the antenna determining the resonating frequency and the quality factor of said cavity-backed antenna, wherein said cavity is formed when assembling the first part of housing, the second part of housing and the printed circuit board. In variant embodiments, the antenna is one of a slot antenna or a patch antenna. According to variant embodiments, said walls are realized by die-cast, by machining or realized by separate metallic parts fixed to the first part of housing. In a variant embodiment, an electrical connection between said walls of first part of housing and said ground plane of said printed circuit board. Said electrical connection is realized using at least one of metallic foam, spring contacts, solder paste.

In a second aspect, a spacer is positioned between said first part of housing and said second part of housing, said spacer providing a gap between the first part of housing and second part of housing to operate the slot antenna. In a variant of second aspect, said spacer is made of a dielectric material.

In a third aspect, at least one part of the metal housing comprises at least one die-casted or machined slot providing an opening in the metal housing to operate the slot antenna. In a variant of third aspect, said opening in the metal housing is filled with a dielectric material.

In a fourth aspect, said device is designed to stand horizontal, so that the first part of housing corresponds to a top housing and the second part of housing corresponds to a bottom housing.

In a fifth aspect, said device is designed to stand vertical, so that the first part of housing corresponds to one of the left, right, front or rear housing and the second part of housing correspond to the opposite side.

In a variant of previous aspects, said second part of housing further comprises walls erected from said second part of housing towards the printed circuit board.

### BRIEF DESCRIPTION OF DRAWINGS

Preferred features of the present disclosure will now be described, by way of non-limiting example according to a preferred embodiment, with reference to the accompanying drawings, in which:
Figure 1A illustrates a perspective view of a wireless communication device according to the preferred embodiment;
Figure 1B illustrates an exploded view showing the assembly of different parts of the wireless communication device comprising top housing, spacer, optional shielding, printed circuit board and bottom housing;
Figure 2A illustrates a perspective view of the top housing;
Figure 2B illustrates a perspective view of the spacer;
Figure 2C illustrates a perspective view of the printed circuit board;
Figure 2D illustrates a perspective view of the bottom housing;
Figure 3A illustrates a perspective view of a wireless communication device according to an alternate embodiment without spacer integrating four 5 GHz antennas;
Figure 3B illustrates perspective views of a wireless communication device according to an alternate embodiment where fake slots are inserted for aesthetical reasons;
Figure 3C illustrates perspective views of a wireless communication device according to an alternate embodiment where fake slots with different aspects are inserted for aesthetical reasons;
Figure 3D illustrates a perspective view of a wireless communication device according to an alternate embodiment where slot antennas are replaced by patch antennas.

### DESCRIPTION OF EMBODIMENTS

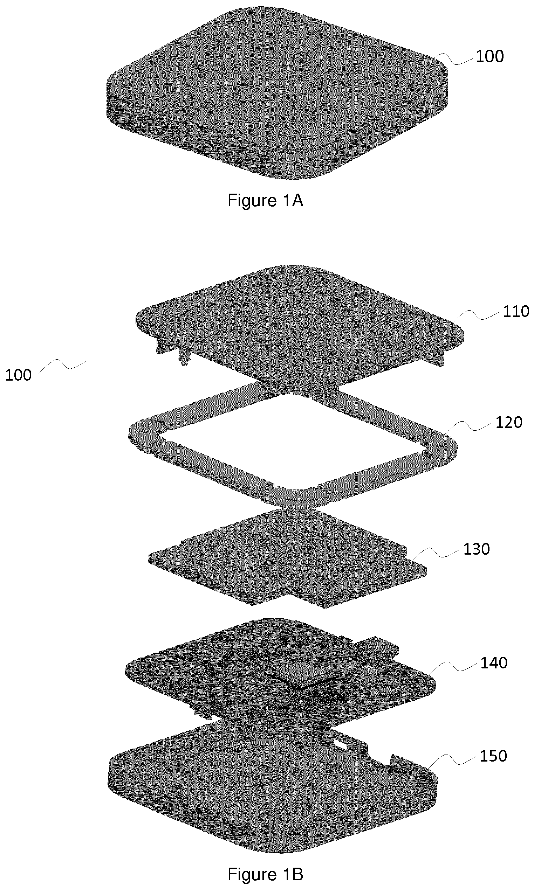

Figure 1A illustrates a perspective view of a wireless communication device according to a preferred embodiment. In the preferred embodiment, the device 100 is a set top box. It comprises four 5 GHz antennas for WiFi and one 2.4 GHz antenna for Bluetooth wireless communications, although not illustrated in Figure 1A. Connectivity to other devices, such as a television for rendering, is provided through various connectors such as Universal Serial Bus type-C (USB-C) or High-Definition Multimedia Interface (HDMI). The device integrates decoding capabilities of audio visual signals received either through the wireless communication or through the physical connectors as well as interaction with the user through a user interface. The housing of the device is mainly made of metal, therefore making it challenging to integrate wireless communication capabilities with good performances.

**Figure 1** **B** illustrates an exploded view showing the assembly of the different parts of the device 100, according to the preferred embodiment. A top housing 110 is realized in metal, either by using die casting or machining techniques and forms the first part of the cavity-backed antenna. A spacer 120 allows to form a gap between the top housing 110 and the bottom housing 150, forming for example a slot type antenna. This spacer is preferably realized in dielectric material (ABS material for example) which reduces the antenna sizes, but can be also an air filled zone which can increase the antenna efficiency. The gap width controls both the antenna bandwidth and efficiency. This mechanical part can be realized by molded injection technique. An optional shielding 130 is soldered or fixed onto a printed circuit board 140 to reduce noise in the device. An optional thermal pad can be applied between an electronic component and one or both metal parts of the housing. The inner sides of the top or bottom housing can be mechanically matched in order to reduce the thermal pad height for cost saving reasons. The printed circuit board 140 forms the second part of the cavity-backed antenna. In this cavity surface area the printed circuit board comprises at least one conductive layer. A bottom housing 150 is realized in metal, either by using die casting or machining techniques and forms the third part of the cavity-backed antenna. Walls are erected from the top housing 110 towards the printed circuit board 140 and constitute protuberances that form the fourth part of the cavities and close the cavities on the remaining areas such as on the sides. The cavities are therefore formed by the assembly of top housing, printed circuit board and bottom housing. Before assembling the parts together, the cavities do not exist. Each cavity is linked from RF circuitry to an antenna conductor feeder which is either directly connected with the top and/or the bottom housing forming the (slot) antenna or electromagnetically coupled to the (slot) antenna.

The robustness of the metal housing allows to minimize the size of the housing. In the preferred embodiment, the length and width of the device is around 12 centimetres and the height of the device is less than 2 centimetres.

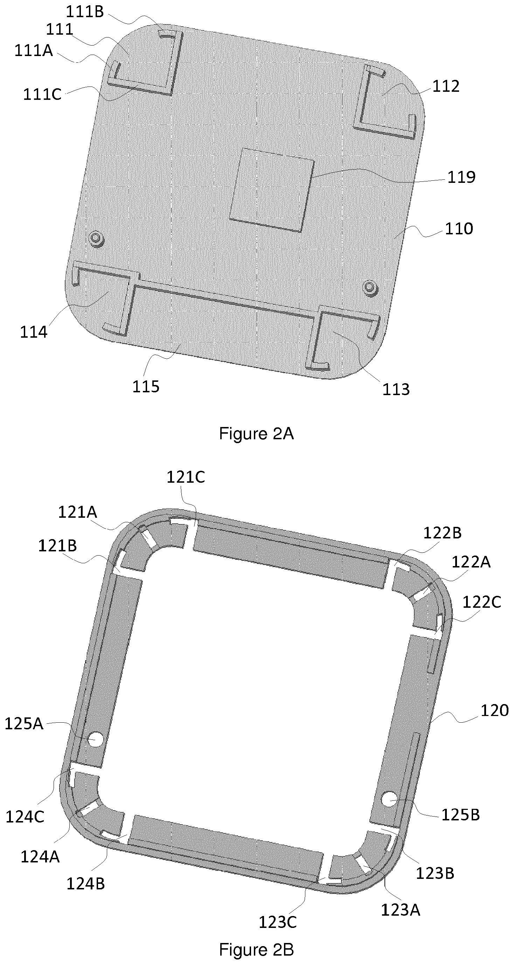

**Figure 2A** illustrates a perspective view of the top housing 110. Areas 111, 112, 113, 114 are representing the fourth parts of the cavities of the 5 GHz antennas. Taking the example of cavity 111, the first part of the cavity is formed by the surface of the top housing 110, completed by the side walls 111A, 111B and by the rear wall 11C. These walls are either formed in the top surface or fixed to the top surface as a separate metallic part. In order to enable wide band frequency applications, the quality factor of the cavity should be minimized. The side walls allow the adjustment of the resonating frequency of the cavity-backed antenna. The form and dimension of the walls is determined by simulations according to the overall form of the device. For example, rounded (not straight), inclined (not perpendicular) walls or more complex wall shapes could be used although in the preferred embodiment the walls are straight and perpendicular to the top housing 110, as depicted in figure 2A. The four 5 GHz cavities are arranged to propose a radiation pattern diversity so as for example to propose a complementary radiation pattern in the horizontal plane of the device. Higher MIMO order, therefore requiring a higher number of antennas, can be addressed with this arrangement by adding slot aperture on the same device edge (between current 5 GHz antennas in each corner), or by creating additional aperture in this first part of the metal housing. The cavity 115 is dedicated to 2.4GHz. The principles described above apply for this cavity.

**Figure 2B** illustrates a perspective view of the spacer. The spacer 120 comprises multiple cuts or openings in the dielectric. Cuts 121A, 122A, 123A, 124A are arranged to support the antenna feeder. Cuts 121B, 121C, 122B, 122C, 123B, 123C, 124B, 124C are arranged to insert the top housing and are particularly adapted to fit to the walls integrated into the top housing. Optionally, holes 125A, 125B are arranged to allow insertion of the top housing and to provide guidance for positioning and maintaining the spacer towards the top housing.

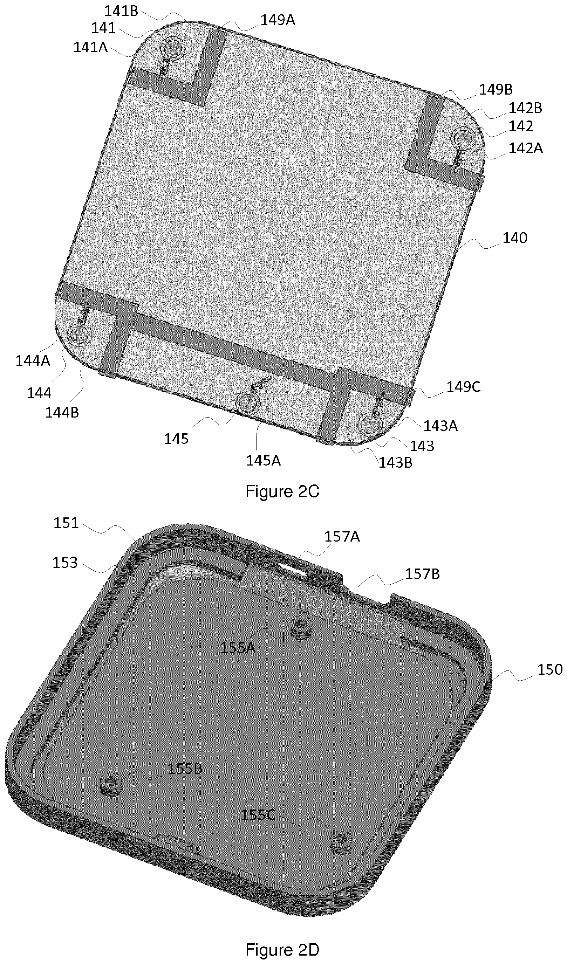

**Figure 2C** illustrates a perspective view of the printed circuit board. The printed circuit board 140 hosts the electronic components that provide the functionality of the device. These components are not shown in the figure. It comprises conductor pads 141, 142, 143, 144, 145 allowing the contact of an antenna feeder (not represented) to the slot antenna, antenna driving circuits 141 A, 142A, 143A, 144A, 145A. The cavity areas 141 B, 142B, 143B, 144B use filled conductor and plated through holes may be added to increase the energy transfer from the printed circuit board to the antenna. Ground planes 149A, 149B, 149C are arranged on the top layer of the printed circuit board, coating-free, to ensure good ground connection with the walls of the top cover. Indeed electric contacts between the printed circuit board and the walls of the top cover ensure an electromagnetic sealing of the cavity. The contact points between the printed circuit board and the wall of the top housing are distant by less than a quarter of the wavelength and preferably the contacts are nearly continuous, for example through the use of metallic foam. The person skilled in the art will appreciate that several solutions may be used to ensure the electrical connection between the wall of the top cover and the ground plane on the printed circuit board such as spring contacts, solder paste, or metallic foam.

**Figure 2D** illustrates a perspective view of the bottom housing. The vertical part 151 and the horizontal part 153 of the bottom housing 150 form the third part of the cavities for each of the backed cavity antennas. Indeed, the horizontal part is required to close the cavity since the printed circuit board does not fit perfectly to the vertical part: some free space needs to be provisioned around the printed circuit board to allow its assembly. Optionally, holes 155A, 155B, 155C are used to fix the printed circuit board onto the bottom housing 150 and holes 157A, 157B are used to interface the device with external elements by connecting cables or devices, such as DC power unit, HDMI, USB, USB-C, etc. Optionally, the bottom housing can also integrate walls similar to the walls integrated to the top housing in order to further improve the isolation of the cavities.

The person skilled in the art will appreciate that other arrangements of the different elements composing the device are possible. For example, when the device is standing up (being mostly vertical and not mostly horizontal as described in the Figure 1), the top and bottom housings are replaced by left and right housings or front and rear housings, without altering the principle of the invention. The position of the antenna can also be changed with minor impact of the performances. For example, the 5 GHz antennas could be placed in the middle of each side of the device and the 2.4 GHz antenna could be placed in a corner of the device. Any other number of antennas could be used. For example, doubling the number of antennas of the preferred embodiment using 8 antennas for the 5 GHz and 2 for the 2.4 GHz, the antennas being distributed over the sides, corner, and top of the housing.

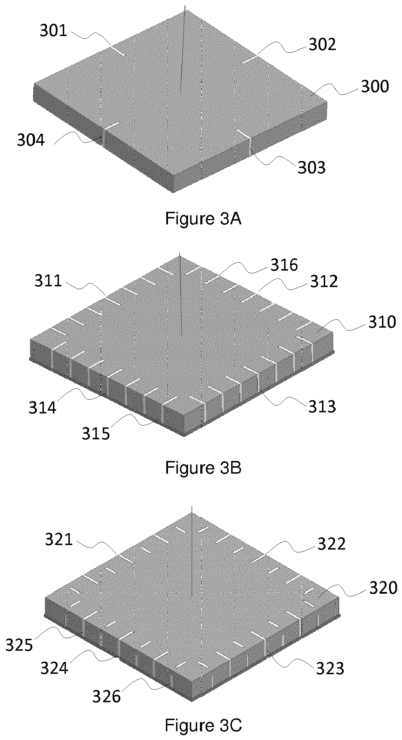

**Figure 3A** illustrates a perspective view of a wireless communication device 300 according to an alternate embodiment without spacer integrating four 5 GHz antennas. In this embodiment, there is no spacer between the top and the bottom housing therefore forming a full metal housing. Each slot antenna 301, 302, 303, 304 is realized by a slot in the metal housing, the opening being made either by using die casting or machining techniques. This slot antenna uses similar cavities than those described in the preferred embodiment and therefore all principles described above apply to this alternate embodiment. For example, the slot may be left opened (air filled zone) or filled with dielectric material.

**Figure 3B** illustrates perspective views of a wireless communication device 310 according to an alternate embodiment where fake slots 315, 316 are inserted for aesthetical reasons. In this case, only the slots 311,312,313,314 are used as slot antennas. The other slots have identical aspect but have no associated slot antenna function.

**Figure 3C** illustrates perspective views of a wireless communication device 320 according to an alternate embodiment where fake slots 325, 326 with different aspects are inserted for aesthetical reasons. In this case, only the slots 321, 322, 323, 324 are used as slot antennas. The other slots, either with identical aspect such as slot 325 or with different aspects such as slot 326, have no associated slot antenna function.

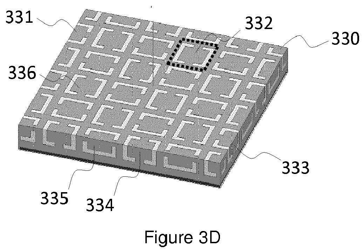

**Figure 3D** illustrates a perspective view of a wireless communication device 330 according to an alternate embodiment where slot antennas are replaced by patch antennas. In this embodiment, the opening in the metal housing comprises a double opening in "C" shape and inverted "C" shape, as highlighted by the dotted square. This shape forms a pattern that is replicated all over the housing. Some of these shapes are active and have an associated patch antenna function while others (patch 335, 336) are inserted only for aesthetical reasons and have no associated antenna function. The pattern may be implemented on a single plane (a surface of the housing like the patch antenna 332), on two planes (a border of the housing like the patch antenna 331, 333, 334) or on three planes (on a corner of the housing, not illustrated). The slot may be left opened (air filled zone) or filled with dielectric material. The principles related to the cavities also apply to this kind of antenna.

The metal housing can advantageously be used for heat dissipation of the electronic components. In Figure 2A, the square protuberance 119 on the top housing is a contact area for the processor of the device and is used to transfer heat from the processor to the metal housing. The assembly of the elements ensures that the top surface of the processor is physically in contact with this square protuberance. A thermal paste is preferably used to improve the heat transfer.

Although the description has been done with a housing realized in metal, the person ordinarily skilled in the art will understand that the housing can also be realized in non-metallic materials (such as plastic, ceramic, glass, organic materials, etc.) whose surface is being metallized, therefore obtaining the same effects, except the increased robustness and thermal efficiency for some materials.

It will be appreciated that one of the advantage of the invention is that the assembly can be done "in the blind" while allowing precise positioning of the antenna feeder towards the patch or slot antenna the provide good antenna performances. Moreover, the number of operations requires for the assembly is reduced since part of the cavity walls are integrated into the housing and electrical contacts of the feeders are done automatically when assembling the elements together without additional manipulation to connect connectors together or soldering of the feeder.

The description is done according to a classical parallelepipedal device housing shape where the height of the device is smaller than the width therefore determining a "top" and a "bottom". If other proportions or other shapes are used, the definition of "top" may no more be related to the physical position of the elements. The term "top", as used in the description, defines the surface that closes the cavity by covering it. In case of an up-standing device whose height is larger than its width, the top corresponds to one of the sides.

Electronic device 100 can also be any other electronic device comprising an antenna as described, such as a gateway, a tablet, a smartphone, a head-mounted display for instance.

## Claims

1. An electronic device (100) configured to perform wireless communications, comprising:
- a housing comprising a first part of housing (110) and a second part of housing (150), said housing being realized in metallic material or realized in non-metallic material that is metallized on its surface;
- a printed circuit board (140) comprising electronic components configured to provide at least wireless communications capabilities, the electronic components comprising at least a driving circuit for at least one antenna feeder, said printed circuit board comprising a ground plane on a first surface;
- at least one cavity-backed antenna fed by an antenna feeder, wherein a first part of said cavity is formed by said first part of housing, a second part of said cavity is formed by the ground plane of the first surface of the printed circuit board a third part of said cavity is formed by said second part of housing and a fourth part of said cavity is formed by walls erected from said first part of housing towards the first surface of the printed circuit board, the dimensions and positions of said walls with regards to the antenna determining the resonating frequency and the quality factor of said cavity-backed antenna,
wherein said cavity is formed when assembling the first part of housing (110), the second part of housing (150) and the printed circuit board (140).

2. The electronic device according to claim 1 wherein the antenna is one of a slot antenna or a patch antenna.

3. The electronic device according to claim 1 or claim 2 wherein said walls are realized by die-cast.

4. The electronic device according to claim 1 or claim 2 wherein said walls are realized by machining.

5. The electronic device according to claim 1 or claim 2 wherein said walls are separate parts fixed to the first part of housing.

6. The electronic device according to any of claim 1 to 5 further comprising an electrical connection between said walls of first part of housing and said ground plane of said printed circuit board.

7. The electronic device according to claim 6 wherein said electrical connection is realized using at least one of metallic foam, spring contacts, solder paste.

8. The electronic device according to any of claims 1 to 7 further comprising a spacer positioned between said first part of housing and said second part of housing, said spacer providing a gap between the first part of housing and second part of housing to operate the slot antenna.

9. The electronic device according to claim 8 wherein the spacer is made of a dielectric material.

10. The electronic device according to any of claims 1 to 7 wherein at least one part of the metal housing comprises at least one die-casted or machined slot providing an opening in the metal housing to operate the slot antenna.

11. The electronic device according to claim 10 wherein said opening in the metal housing is filled with a dielectric material.

12. The electronic device according any of claims 1 to 11 wherein said device is designed to stand horizontal, so that the first part of housing corresponds to a top housing and the second part of housing corresponds to a bottom housing.

13. The electronic device according to any of claims 1 to 12 wherein said device is designed to stand vertical, so that the first part of housing corresponds to one of the left, right, front or rear housing and the second part of housing correspond to the opposite side.

14. The electronic device according to claim 1 wherein said walls are straight.

15. The electronic device according to claim 14 wherein said walls are perpendicular to said second part of housing.
